(19) Europäisches Patentamt / European Patent Office / Office européen des brevets

(11) **EP 3 550 530 B1**

(12) **EUROPEAN PATENT SPECIFICATION**

(45) Date of publication and mention
of the grant of the patent:
**17.11.2021 Bulletin 2021/46**

(51) Int Cl.:
**G07C 9/00** *(2020.01)*    *G01R 31/36* *(2020.01)*
**H02J 7/00** *(2006.01)*

(21) Application number: **19167378.9**

(22) Date of filing: **04.04.2019**

(54) **OBTAINING REMAINING BATTERY LIFESPAN**

ERHALTEN DER VERBLEIBENDEN BATTERIELEBENSDAUER

OBTENTION DE LA DURÉE DE VIE DE BATTERIE RESTANTE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.04.2018 IN 201811012753**

(43) Date of publication of application:
**09.10.2019 Bulletin 2019/41**

(73) Proprietor: **Carrier Corporation
Palm Beach Gardens, FL 33418 (US)**

(72) Inventors:
• **LINGALA, Ramesh
500081 Telangana (IN)**
• **SANTHOSH, Amuduri
500081 Telangana (IN)**
• **DUMBALA, Mohan Reddy
500081 Telangana (IN)**

(74) Representative: **Dehns
St. Bride's House
10 Salisbury Square
London EC4Y 8JD (GB)**

(56) References cited:
**CN-A- 107 656 200    JP-A- 2011 108 166
US-A- 5 046 084    US-A1- 2009 256 676**

**Description**

The invention relates to battery powered access control devices, and more particularly, to methods and systems for obtaining a battery lifespan of one or more access control devices.

Existing access control devices (e.g., locks) utilize a battery and lock battery life is calculated theoretically based on a number of access events (e.g., open/close operations) estimated to, for example, a number of years. Sometimes these estimates are inaccurate, which may lead to a sudden requirement to replace the batteries. Also, a lock battery may drain faster than expected due to a fault, such as leakage.

US5046084 A describes a battery monitoring system for a lockbox. When a new battery is installed, a battery capacity number is stored. When a low battery condition is detected based on usage, it loads a battery count number, such as 16, in its memory. This battery count number is then decremented each time a lockbox or key operation is performed. Each time the lockbox and the key communicate, the lockbox indicates to the key the status of the lockbox battery.

According to a first aspect, the invention provides a method of determining the remaining battery lifespan in an access control device including determining a reference number of access events for the battery access control device to transition from an initial voltage to a low voltage condition; collecting, in real time, access events, along with the current voltage of the battery at the access control device; comparing the number of access events at the access control device to the reference number of access events; determining the remaining battery lifespan in response to the number of access events at the access control device and the reference number of access events; generating a trend report for the access control device, the trend report relating battery voltage to the number of access events; comparing the trend report to an average trend report, derived by averaging the trend reports for a plurality of access control devices; and identifying the access control device as having a fault in response to the comparing if the trend report differs from the average trend report by more than a threshold.

Optionally, determining the battery lifespan comprises: determining: number of days until low voltage condition = cumulative days * max supported access events / cumulative number of access events; where cumulative days is a number of days the access device has been in service; max supported access events is the reference number of access events; and cumulative number of access events is a count of the total number of access events experienced by the access control device over the cumulative days.

The method may include generating a battery lifespan report in response to the battery lifespan.

Optionally, the access control device is a lock.

Optionally, the access event is one of locking and unlocking the lock.

According to a second aspect, the invention provides a system including an access control device having a battery; a server in communication with the access control device, the server configured to: determine a reference number of access events for the battery to transition from an initial voltage to a low voltage condition; collect, in real time, access events, along with the current voltage of the battery at the access control device; compare the number of access events at the access control device to the reference number of access events; determine the remaining battery lifespan in response to the number of access events at the access control device and the reference number of access events; generate a trend report for the access control device, the trend report relating battery voltage to the number of access events; compare the trend report to an average trend report, derived by averaging the trend reports for a plurality of access control devices; and identify the access control device as having a fault in response to the comparing if the trend report differs from the average trend report by more than a threshold.

Optionally, determining the battery lifespan comprises: determining: number of days until low voltage condition = cumulative days * max supported access events / cumulative number of access events; where cumulative days is a number of days the access device has been in service; max supported openings is the reference number of access events; and cumulative number of access events is a count of the total number of access events experienced by the access control device over the cumulative days.

Optionally, the server is configured to generate a battery lifespan report in response to the battery lifespan.

Optionally, the access control device is a lock.

Optionally, the access event is one of locking and unlocking the lock.

According to a third aspect, the invention provides a computer program product for determining the remaining battery lifespan in an access control device, the computer program product comprising a non-transitory computer readable storage medium having program instructions embodied therewith, the program instructions executable by a processor to cause the processor to implement operations comprising: determining a reference number of access events for the battery to transition from an initial voltage to a low voltage condition; collecting, in real time, access events, along with the current voltage of the battery at the access control device; comparing the number of access events at the access control device to the reference number of access events; determining the battery lifespan in response to the number of access events at the access control device and the reference number of access events; generating a trend report for the access control device, the trend report relating battery voltage to the number of access events; comparing the trend report to an average trend report, derived by averaging the trend reports for a plurality of access control devices; and identifying the access control device as having a fault in response to the comparing if the trend report differs from the average trend report by more than a threshold.

Technical effects of embodiments of the present disclosure include detecting, in real time, a battery fault in an access control device and estimating, in real time, battery lifespan of an access control device.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

The present disclosure is illustrated by way of example and not limited in the accompanying figures in which like reference numerals indicate similar elements.

FIG. 1    depicts a system;

FIG. 2    depicts an access control device, user devices and a server;

FIG. 3    depicts a flowchart of a process for providing battery lifespan;

FIG. 4    depicts trend reports; and

FIG. 5    depicts a battery lifespan report.

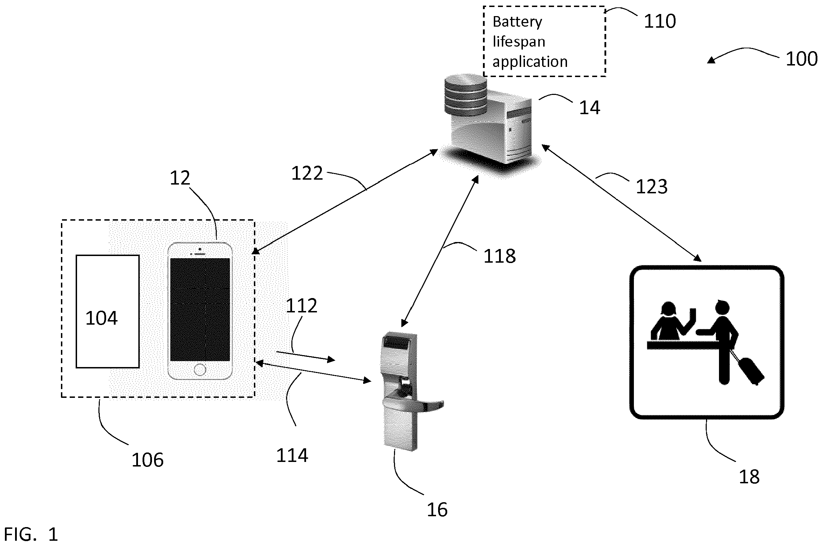

FIG. 1 depicts a general schematic system diagram of an access control system 100. The system 100 generally includes a user device 106, an access control device 16, a server 14, and a remote device 18. In an example, the access control device 16 is a guest room door lock in a hotel environment and the remote device 18 is a computer at a front desk of the hotel. It is understood that embodiments may apply to a wide variety of environments, including hotels, educational facilities, commercial buildings, etc. It should be appreciated that while one access control device 16 is illustrated, the access control system 100 may include any number of access control devices 16. It should be appreciated that, although particular systems are separately defined in the schematic block diagrams, each or any of the systems may be otherwise combined or separated via hardware and/or software.

In an example, the access control device 16 includes a lock that controls access through a door. It should be appreciated that the access control system 100 may include any number of doors and rooms. Further, there may be multiple doors and access control devices 16 for each room.

A hotel guest uses the user device 106 to unlock and/or lock the access control device 16 operably connected to their assigned room. The state of the access control device 16 can be changed from locked to unlocked through an access request 112 from the user device 106 being sent to the access control device 16 via a short-range wireless communication interface 114. The short-range wireless communication interface 114 can be implemented by any short-range wireless communication method known in the art such as, but not limited to: Wi-Fi, Bluetooth, Zigbee, and infrared.

The user device 106 may store credentials to unlock and/or lock the access control device 16. Some credentials may be used for multiple access control devices 16 if there are multiple access control devices 16 for a single assigned room or the hotel guest is assigned access to multiple rooms. For example, an access control device 16 operably connected to a hotel room and an access control device 16 operably connected to a common area (e.g., hotel pool, elevator access, fitness center, etc.) may respond to the same credential. Other credentials may be specific to a single access control device 16.

The user device 106 may be a physical key card 104 and/or a mobile device 12. The user device 106 may transmit an access request 112 to the access control device 16 via the short-range wireless transmission interface 114 when the user device 106 is placed proximate to (i.e., within the range of the short-range wireless transmission interface) the access control device 16. The mobile device 12 or an RFID key card 104 transmit an access request and credential when proximate to the access control device 16. Alternatively, when the user device 106 is a key card 104 having an encoded magnetic stripe, an access request 112 can be transmitted to the access control device 16 by the user device 106 being inserted into the access control device 16 for the access control device 16 to read the key card 104. The data may include credentials to grant access to a specific access control device 16. For example, for a period of stay of the hotel guest, the user device 106 may be granted access to a specific access control device 16.

In an example, the mobile device 12 is a wireless capable handheld device such as a smartphone that is operable to communicate with the server 14 via a wireless communication interface 122. The wireless communication interface 122 may be implemented by any short or long-range wireless communication method known in the art over networks such as, but not limited to the Internet, a local area network (LAN), and a wide area network (WAN). Although the server 14 is depicted herein as a single device, it should be appreciated that the server 14 may alternatively be embodied as a multiplicity of systems, from which the mobile device 12 receives credentials and other data via communication interface 122.

In addition, the server 14 may communicate with the access control device 16 via communication interface 118. The communication interface 118 may be implemented by any short or long-range wireless communication method known in the art over networks such as, but not limited to the Internet, a local area network (LAN), and a wide area network (WAN).

The access control device 16 may be a wireless-capable, restricted-access, or restricted-use device such as a wireless lock, access control reader for building entry, and other restricted-use machine. The user device 106 submits credentials to the access control device 16, thereby selectively permitting a user to access or activate functions of the access control device 16. A user device 106 may, for example, submit a credential to an electromechanical lock to unlock it, and thereby gain access to a room at the hotel.

As described in further detail herein, the server 14 collects the occurrence of access events (e.g., a lock or unlock event) at the access control device 16. In one example, the access control device 16 communicates directly with the server 14 over the communication interface 118. Physical key cards cannot communicate with the server 14. If a user does not have mobile device and only has a physical key card, then using a wireless communication interface 118, the access control device 16 sends an access event packet to the server 14. The access control device 16 may communicate directly with the server if equipped with a long range wireless transceiver (e.g., 802.1x). Alternatively, the access control device 16 may communicate with a nearby access control device 16, and so on, until the communication reaches the server using a mesh of short range wireless transceivers (e.g., Bluetooth mesh). The access control device 16 sends a notification of an access event to the server 14 and a current voltage level of a battery installed in the access control device 16.

In other examples, the mobile device 12 sends a notification of an access event to the server 14 and the current voltage level of a battery installed in the access control device 16 over wireless communication interface 122. In this way, access events from either the mobile device 12 or the physical key card 104 are communicated to the server 14 along with current voltage level of a battery installed in the access control device 16.

In an example, the server 14 executes a battery lifespan application 110. The server 14 may include one or more processors, memory, communication modules, etc. The battery lifespan application 110 may be stored in memory and executed by one or processors to perform the operations described herein. The server 14 communicates battery lifespan results to a remote device 18 as described herein. The server 14 may communicate with the remote device over a communication interface 123, which may include wireless networks, wired networks, or a combination thereof. The remote device 18 may be processor-enable device (a personal computer, tablet, smartphone, etc.) capable of receiving the battery lifespan results.

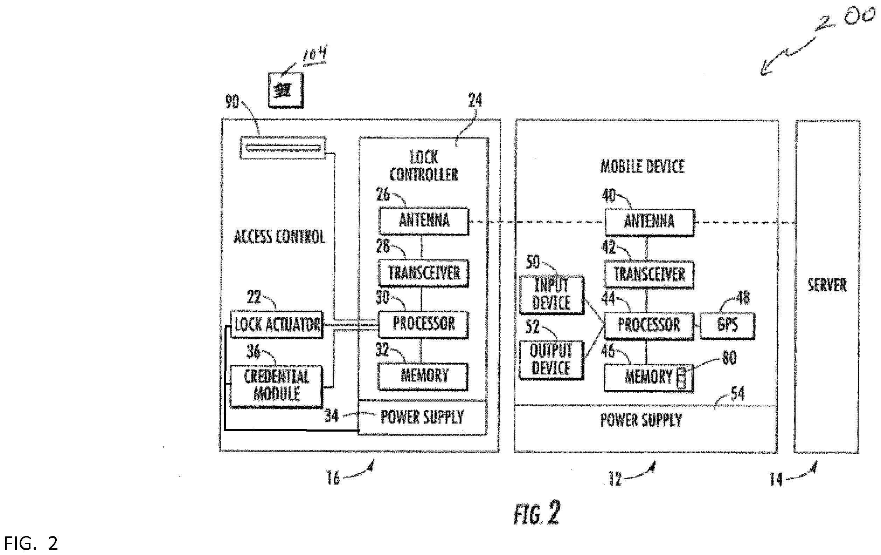

With reference to FIG. 2, a block diagram of an example electronic lock system 200 includes the access control device 16, the mobile device 12 and the server 14. The access control device 16 generally includes a lock actuator 22, a lock controller 24, a lock antenna 26, a lock transceiver 28, a lock processor 30, a lock memory 32, an access control device power supply 34, a lock card reader 90 and a credential module 36. The access control device 16 may have essentially two readers, one reader 90 to read a physical key card 104 and the credential module 36 to communicate with the mobile device 12 via the lock processor 30 and the transceiver 28 and antenna 26. The access control device 16 is responsive to credentials from the mobile device 12, and may, for example, be the lock of a turnstile or a door lock. Although the present disclosure focuses primarily on credentials for access control, it should be appreciated that other systems wherein credentials are transmitted from a mobile device to an access control device so as to identify the user to an online system or validate user access rights or permissions in an offline system will benefit therefrom.

Upon receiving and authenticating an appropriate credential from the mobile device 12 using the credential module 36, or after receiving card data from lock card reader 90, the lock controller 24 commands the lock actuator 22 to lock or unlock a mechanical or electronic lock. In this manner, a lock state of the access control device 16 changes from one state to another state. The lock controller 24 and the lock actuator 22 may be parts of a single electronic or electromechanical lock unit, or may be components sold or installed separately.

The lock transceiver 28 is capable of transmitting and receiving data to and from at least the mobile device 12. The lock transceiver 28 may, for instance, be a near field communication (NFC), Bluetooth, infrared, Zigbee, or Wi-Fi transceiver, or another appropriate wireless transceiver. The lock antenna 26 is any antenna appropriate to the lock transceiver 28. The lock processor 30 and lock memory 32 are, respectively, data processing, and storage devices. The lock processor 30 may, for instance, be a microprocessor that can process instructions to validate credentials and determine the access rights contained in the credentials or to pass messages from a transceiver to a credential module 36 and to receive a response indication back from the credential module 36. The lock memory 32 may be RAM, EEPROM, or other storage medium where the lock processor 30 can read and write data including but not limited to lock access events. The lock access events described herein may be a unified audit trail that includes events initiated by accessing the lock via a mobile device 12 or key card 104. The access control device power supply 34 is a power source such as a battery that powers the lock controller 24, credential module 36 and lock actuator 22.

While FIG. 2 shows the lock antenna 26 and the transceiver 28 connected to the processor 30, this is not to limit other examples that may have additional antenna 26 and transceiver 28 connected to the credential module 36 directly. The credential module 36 may contain a transceiver 28 and antenna 26 as part of the credential module. Or the credential module 36 may have a transceiver 28 and antenna 26 separately from the processor 30 which also has a separate transceiver 28 and antenna 26 of the same type or different. In some examples, the processor 30 may route communication received via transceiver 28 to the credential module 36. In other examples the credential module may communicate directly to the mobile device 12 through the transceiver 28.

The mobile device 12 generally includes a key antenna 40, a key transceiver 42, a key processor 44, a key memory 46, a GPS receiver 48, an input device 50, an output device 52, and a key power supply 54. The key transceiver 42 is a transceiver of a type corresponding to the lock transceiver 28, and the key antenna 40 is a corresponding antenna. In some examples, the key transceiver 42 and the key antenna 40 may also be used to communicate with the server 14. In other examples, one or more separate transceivers and antennas may be included to communicate with server 14. The key memory 46 is of a type to store a plurality of credentials locally on the mobile device 12. The mobile device 12 may also include a mobile device application 80. Examples disclosed herein, may operate through the mobile device application 80 installed on the mobile device 12.

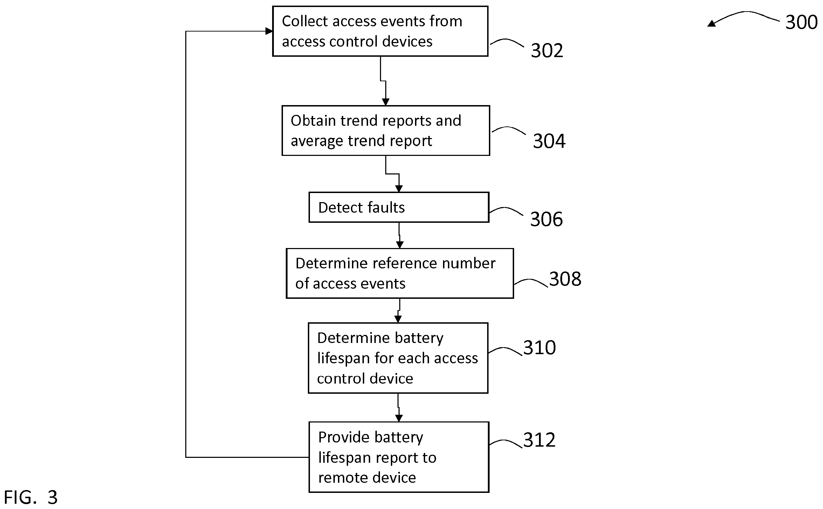

Turning now to FIG. 3, a flow diagram 300 illustrating a process for determining battery lifespan of one or more access control devices 16. The process begins at 302 where the server 14 collects real time access events from a plurality of access control devices 16. When an access control device is accessed (e.g., locked or unlocked) an access event is sent to the server 14, along with the current voltage of the battery at the access control device 16. As the server 14 collects access events and current battery voltages, the server 14 generates trend reports for each access control device 16.

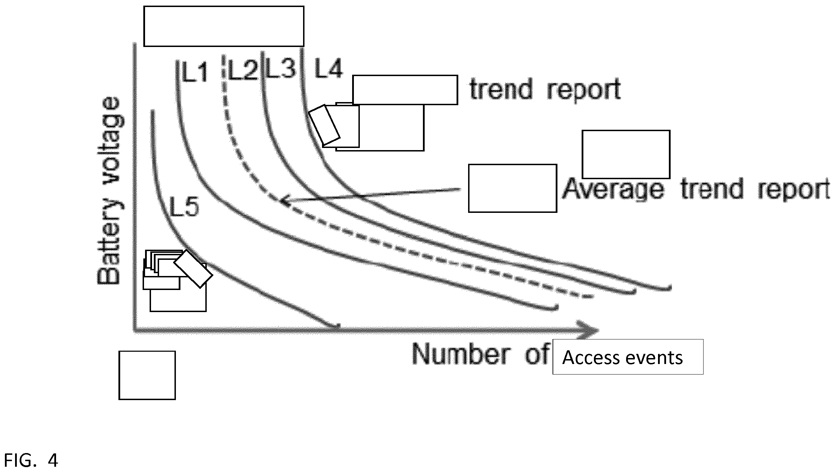

At 304, the server 14 determines trend reports for each access control device 16 and an average trend report. FIG. 4 depicts example trend reports relating battery voltage to number of access events for five access control devices L1-L5. An average trend report is derived by averaging the trend reports for all access control devices at one facility, or all access control devices across multiple facilities.

At 306, server 14 determines if any of the batteries of the access control devices 16 is faulty by comparing each trend report to the average trend report. If a trend report differs from the average trend report by more than a threshold, a fault may be noted. The difference between a trend report and the average trend report may be determined by summing the differences between the trend report and the average trend report across access events. The fault may be indicative of a leaking battery or otherwise faulty access control device 16.

After processing the trend reports for faults, flow proceeds to 308 where the server 14 determines a reference number of access events for a battery of an access control device 16 to go from an initial voltage (e.g., 6.4 volts) to a low voltage condition (e.g., 4.8 volts). The reference number of access events may be based on the trend report for a single access control device or from the average trend report. In an example, the voltage decrease at an access control device 16 is linearly proportional to the number of access events at that access control device 16. In other words, as the number of access events increases, the voltage decreases linearly. In one example, the battery of an access control device 16 may go from an initial voltage of 6.4 volts to 4.8 volts (e.g., a low voltage condition) after 35,000 access events.

At 310, the server 14 determines the battery lifespan for each of the access control devices 16 based on the total number of access events experienced by each access control device 16 compared to the reference number of access events. For example, if an access control device 16 has a reference number of access events of 35,000 and has already experienced 20,000 access events, the battery lifespan is 15,000 access events. The battery lifespan can also be represented by number of days by considered an average number of access events per day.

In other examples, the battery lifespan may be calculated as:

$$\text{number of days until low voltage condition} = \text{cumulative days} * \text{max supported access events} / \text{cumulative number of access events};$$

where cumulative days is a number of days the access device has been in service;

max supported access events is the reference number of access events; and

cumulative number of access events is a count of the total number of access events experienced by the access control device over the cumulative days.

At 312, the server 14 provides a battery lifespan report for each of the access control devices 16 to the remote device 18. The process loops back to 302 where the server 14 continually obtains access events from the access control devices 16 and updates the battery lifespan report in real time. In this way, the battery lifespan for each of the access control devices 16 is updated in real time to the remote device 18.

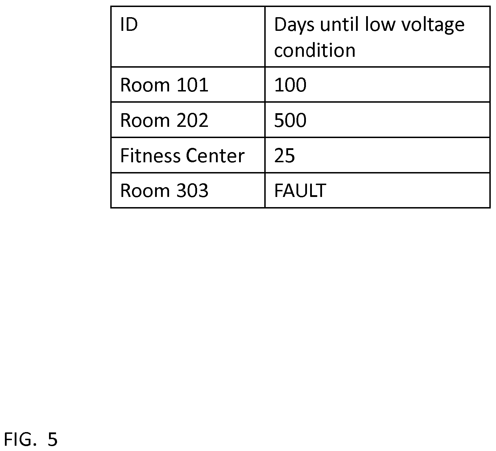

FIG. 5 presents an example battery lifespan report provided to remote device 18. The battery lifespan report may include an identifier of the access control device 16 and an estimated time (e.g., number of days) until the battery of an access control device 16 is at the low voltage condition.

The access control device 16 for room 303 has a trend report that indicates a fault, such as battery leakage. The access control device 16 for room 303 is identified as faulty because the difference between the trend report for access control device 16 for room 303 and the average trend report is not within tolerable limits. In such cases, the access control device is considered faulty.

Embodiments provide the ability to detect battery faults and provide battery lifespan in real time. This is beneficial in facilities having a large number of access control devices, such as locks in a hotel, educational facility, commercial building, etc. The system tracks actual usage of access control devices to better estimate battery lifespan and detects faults in real time.

As described above, embodiments can be in the form of processor-implemented processes and devices for practicing those processes, such as a processor. Embodiments can also be in the form of computer program code containing instructions embodied in tangible media, such as network cloud storage, SD cards, flash drives, floppy diskettes, CD ROMs, hard drives, or any other computer-readable storage medium, wherein, when the computer program code is loaded into and executed by a computer, the computer becomes a device for practicing the embodiments. Embodiments can also be in the form of computer program code, for example, whether stored in a storage medium, loaded into and/or executed by a computer, or transmitted over some transmission medium, loaded into and/or executed by a computer, or transmitted over some transmission medium, such as over electrical wiring or cabling, through fiber optics, or via electromagnetic radiation, wherein, when the computer program code is loaded into an executed by a computer, the computer becomes an device for practicing the embodiments. When implemented on a general-purpose microprocessor, the computer program code segments configure the microprocessor to create specific logic circuits.

The term "about" is intended to include the degree of error associated with measurement of the particular quantity and/or manufacturing tolerances based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

Those of skill in the art will appreciate that various example embodiments are shown and described herein, each having certain features in the particular embodiments, but the present disclosure is not thus limited. Rather, the present disclosure can be modified to incorporate any number of variations, alterations, substitutions, combinations, sub-combinations not heretofore described, but which are commensurate with the scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A method of determining the remaining battery lifespan of an access control device (16), the method comprising:

   determining (308) a reference number of access events for the battery of the access control device (16) to transition from an initial voltage to a low voltage condition;
   collecting (302), in real time, access events, along with the current voltage of the battery at the access control device (16);
   comparing (310) the number of access events at the access control device (16) to the reference number of access events;
   determining (310) the remaining battery lifespan in response to the number of access events at the access control device (16) and the reference number of access events;
   generating (304) a trend report for the access control device (16), the trend report relating battery voltage to the number of access events;
   comparing (306) the trend report to an average trend report, derived by averaging the trend reports for a plurality of access control devices (16); and

identifying (306) the access control device (16) as having a fault in response to the comparing if the trend report differs from the average trend report by more than a threshold.

2. The method of claim 1 wherein the access control device (16) is a lock.

3. The method of claim 2 wherein the access event is one of locking and unlocking the lock.

4. A system comprising:

an access control device (16) having a battery;
a server (14) in communication with the access control device (16), the server (14) configured to:

determine (310) a reference number of access events for the battery to transition from an initial voltage to a low voltage condition;
collect (302), in real time, access events, along with the current voltage of the battery at the access control device (16);
compare (310) the number of access events at the access control device (16) to the reference number of access events;
determine (310) the remaining battery lifespan in response to the number of access events at the access control device (16) and the reference number of access events;
generate (304) a trend report for the access control device (16), the trend report relating battery voltage to the number of access events;
compare (306) the trend report to an average trend report, derived by averaging the trend reports for a plurality of access control devices (16); and
identify (306) the access control device (16) as having a fault in response to the comparing if the trend report differs from the average trend report by more than a threshold.

5. The system of claim 4 wherein the access control device (16) is a lock.

6. The system of claim 5 wherein the access event is one of locking and unlocking the lock.

7. A computer program product for determining the remaining battery lifespan of an access control device (16), the computer program product comprising a non-transitory computer readable storage medium having program instructions embodied therewith, the program instructions executable by a processor to cause the processor to implement operations comprising:

determining (308) a reference number of access events for the battery to transition from an initial voltage to a low voltage condition;
collecting, (302) in real time, access events, along with the current voltage of the battery at the access control device (16);
comparing (310) the number of access events at the access control device to the reference number of access events;
determining (310) the battery lifespan in response to the number of access events at the access control device (16) and the reference number of access events
generating (304) a trend report for the access control device (16), the trend report relating battery voltage to the number of access events;
comparing (306) the trend report to an average trend report, derived by averaging the trend reports for a plurality of access control devices (16); and
identifying (306) the access control device (16) as having a fault in response to the comparing if the trend report differs from the average trend report by more than a threshold.

**Patentansprüche**

1. Verfahren zum Bestimmen der verbleibenden Batterielebensdauer einer Zugangskontrollvorrichtung (16), wobei das Verfahren Folgendes umfasst:

Bestimmen (308) einer Referenzanzahl von Zugangsereignissen für die Batterie der Zugangskontrollvorrichtung (16), um von einem Anfangsspannungs- in einen Niedrigspannungszustand überzugehen;

Erfassen (302) in Echtzeit von Zugangsereignissen zusammen mit der gegenwärtigen Spannung der Batterie an der Zugangskontrollvorrichtung (16);

Vergleichen (310) der Anzahl von Zugangsereignissen an der Zugangskontrollvorrichtung (16) mit der Referenzanzahl von Zugangsereignissen;

Bestimmen (310) der verbleibenden Batterielebensdauer als Antwort auf die Anzahl von Zugangsereignissen an der Zugangskontrollvorrichtung (16) und die Referenzanzahl von Zugangsereignissen;

Erzeugen (304) eines Tendenzberichts für die Zugangskontrollvorrichtung (16), wobei der Tendenzbericht die Batteriespannung mit der Anzahl von Zugangsereignissen in Verhältnis setzt;

Vergleichen (306) des Tendenzberichts mit einem Durchschnittstendenzbericht, der durch Mittelwertbildung der Tendenzberichte für eine Vielzahl von Zugangskontrollvorrichtungen (16) abgeleitet ist; und

als Antwort auf das Vergleichen, Erkennen (306), dass an der Zugangskontrollvorrichtung (16) ein Fehler vorliegt, wenn der Tendenzbericht um mehr als einen Schwellenwert von dem Durchschnittstendenzbericht abweicht.

2.  Verfahren nach Anspruch 1, wobei die Zugangskontrollvorrichtung (16) ein Schloss ist.

3.  Verfahren nach Anspruch 2, wobei das Zugangsereignis eines von Verriegeln und Entriegeln des Schlosses ist.

4.  System, umfassend:

   eine Zugangskontrollvorrichtung (16), die eine Batterie aufweist;

   einen Server (14) in Kommunikation mit der Zugangskontrollvorrichtung (16), wobei der Server (14) für Folgendes konfiguriert ist:

      Bestimmen (310) einer Referenzanzahl von Zugangsereignissen für die Batterie, um von einem Anfangsspannungs- in einen Niedrigspannungszustand überzugehen;

      Erfassen (302) in Echtzeit von Zugangsereignissen zusammen mit der gegenwärtigen Spannung der Batterie an der Zugangskontrollvorrichtung (16);

      Vergleichen (310) der Anzahl von Zugangsereignissen an der Zugangskontrollvorrichtung (16) mit der Referenzanzahl von Zugangsereignissen;

      Bestimmen (310) der verbleibenden Batterielebensdauer als Antwort auf die Anzahl von Zugangsereignissen an der Zugangskontrollvorrichtung (16) und die Referenzanzahl von Zugangsereignissen;

      Erzeugen (304) eines Tendenzberichts für die Zugangskontrollvorrichtung (16), wobei der Tendenzbericht die Batteriespannung mit der Anzahl von Zugangsereignissen in Verhältnis setzt;

      Vergleichen (306) des Tendenzberichts mit einem Durchschnittstendenzbericht, der durch Mittelwertbildung der Tendenzberichte für eine Vielzahl von Zugangskontrollvorrichtungen (16) abgeleitet ist; und

      als Antwort auf das Vergleichen, Erkennen (306), dass an der Zugangskontrollvorrichtung (16) ein Fehler vorliegt, wenn der Tendenzbericht um mehr als einen Schwellenwert von dem Durchschnittstendenzbericht abweicht.

5.  System nach Anspruch 4, wobei die Zugangskontrollvorrichtung (16) ein Schloss isr.

6.  System nach Anspruch 5, wobei das Zugangsereignis eines von Verriegeln und Entriegeln des Schlosses ist.

7.  Computerprogrammprodukt zum Bestimmen der verbleibenden Batterielebensdauer einer Zugangskontrollvorrichtung (16), wobei das Computerprogrammprodukt ein nicht flüchtiges computerlesbares Speichermedium umfasst, mit dem Programmanweisungen dargestellt sind, wobei die Programmanweisungen von einem Prozessor ausführbar sind, um zu verursachen, dass der Prozessor Operationen umsetzt, die Folgendes umfassen:

   Bestimmen (308) einer Referenzanzahl von Zugangsereignissen für die Batterie, um von einem Anfangsspannungs- in einen Niedrigspannungszustand überzugehen;

   Erfassen (302) in Echtzeit von Zugangsereignissen zusammen mit der gegenwärtigen Spannung der Batterie an der Zugangskontrollvorrichtung (16);

   Vergleichen (310) der Anzahl von Zugangsereignissen an der Zugangskontrollvorrichtung (16) mit der Referenzanzahl von Zugangsereignissen;

   Bestimmen (310) der Batterielebensdauer als Antwort auf die Anzahl von Zugangsereignissen an der Zugangskontrollvorrichtung (16) und die Referenzanzahl von Zugangsereignissen;

   Erzeugen (304) eines Tendenzberichts für die Zugangskontrollvorrichtung (16), wobei der Tendenzbericht die Batteriespannung mit der Anzahl von Zugangsereignissen in Verhältnis setzt;

Vergleichen (306) des Tendenzberichts mit einem Durchschnittstendenzbericht, der durch Mittelwertbildung der Tendenzberichte für eine Vielzahl von Zugangskontrollvorrichtungen (16) abgeleitet ist; und

als Antwort auf das Vergleichen, Erkennen (306), dass an der Zugangskontrollvorrichtung (16) ein Fehler vorliegt, wenn der Tendenzbericht um mehr als einen Schwellenwert von dem Durchschnittstendenzbericht abweicht.

**Revendications**

1. Procédé de détermination de la durée de vie de batterie restante d'un dispositif de commande d'accès (16), le procédé comprenant :

   une détermination (308) d'un nombre de référence d'événements d'accès pour que la batterie du dispositif de commande d'accès (16) passe d'une tension initiale à un état de basse tension ;

   une collecte (302), en temps réel, d'événements d'accès, en même temps que la tension courante de la batterie au niveau du dispositif de commande d'accès (16) ;

   une comparaison (310) du nombre d'événements d'accès au niveau du dispositif de commande d'accès (16) au nombre de référence d'événements d'accès ;

   une détermination (310) de la durée de vie de batterie restante en réponse au nombre d'événements d'accès au niveau du dispositif de commande d'accès (16) et au nombre de référence d'événements d'accès ;

   une génération (304) d'un rapport de tendance pour le dispositif de commande d'accès (16), le rapport de tendance associant une tension de batterie au nombre d'événements d'accès ;

   une comparaison (306) du rapport de tendance à un rapport de tendance moyen, déduit en faisant la moyenne des rapports de tendance pour une pluralité de dispositifs de commande d'accès (16) ; et

   une identification (306) du dispositif de commande d'accès (16) comme présentant une défaillance en réponse au fait de comparer si le rapport de tendance diffère du rapport de tendance moyen de plus d'un seuil.

2. Procédé selon la revendication 1 dans lequel le dispositif de commande d'accès (16) est une serrure.

3. Procédé selon la revendication 2 dans lequel l'événement d'accès est un d'un verrouillage et d'un déverrouillage de la serrure.

4. Système comprenant :

   un dispositif de commande d'accès (16) présentant une batterie ;

   un serveur (14) en communication avec le dispositif de commande d'accès (16), le serveur (14) étant configuré pour :

      déterminer (310) un nombre de référence d'événements d'accès pour que la batterie passe d'une tension initiale à un état de basse tension ;

      collecter (302), en temps réel, des événements d'accès, en même temps que la tension courante de la batterie au niveau du dispositif de commande d'accès (16) ;

      comparer (310) le nombre d'événements d'accès au niveau du dispositif de commande d'accès (16) au nombre de référence d'événements d'accès ;

      déterminer (310) la durée de vie de batterie restante en réponse au nombre d'événements d'accès au niveau du dispositif de commande d'accès (16) et au nombre de référence d'événements d'accès ;

      générer (304) un rapport de tendance pour le dispositif de commande d'accès (16), le rapport de tendance associant la tension de batterie au nombre d'événements d'accès ;

      comparer (306) le rapport de tendance à un rapport de tendance moyen, déduit en faisant la moyenne des rapports de tendance pour une pluralité de dispositifs de commande d'accès (16) ; et

      identifier (306) le dispositif de commande d'accès (16) comme présentant une défaillance en réponse au fait de comparer si le rapport de tendance diffère du rapport de tendance moyen de plus d'un seuil.

5. Système selon la revendication 4 dans lequel le dispositif de commande d'accès (16) est une serrure.

6. Système selon la revendication 5 dans lequel l'événement d'accès est un d'un verrouillage et d'un déverrouillage de la serrure.

**7.** Produit programme d'ordinateur permettant de déterminer la durée de vie de batterie restante d'un dispositif de commande d'accès (16), le produit programme d'ordinateur comprenant un support de stockage non transitoire lisible par ordinateur présentant des instructions de programme incorporées à celui-ci, les instructions de programme étant exécutables par un processeur pour amener le processeur à mettre en œuvre des opérations comprenant :

une détermination (308) d'un nombre de référence d'événements d'accès pour que la batterie passe d'une tension initiale à un état de basse tension ;

une collecte (302), en temps réel, d'événements d'accès, en même temps que la tension courante de la batterie au niveau du dispositif de commande d'accès (16) ;

une comparaison (310) du nombre d'événements d'accès au niveau du dispositif de commande d'accès au nombre de référence d'événements d'accès ;

une détermination (310) de la durée de vie de batterie en réponse au nombre d'événements d'accès au niveau du dispositif de commande d'accès (16) et au nombre de référence d'événements d'accès ;

une génération (304) d'un rapport de tendance pour le dispositif de commande d'accès (16), le rapport de tendance associant une tension de batterie au nombre d'événements d'accès ;

une comparaison (306) du rapport de tendance à un rapport de tendance moyen, déduit en faisant la moyenne des rapports de tendance pour une pluralité de dispositifs de commande d'accès (16) ; et

une identification (306) du dispositif de commande d'accès (16) comme présentant une défaillance en réponse au fait de comparer si le rapport de tendance diffère du rapport de tendance moyen de plus d'un seuil.

FIG. 1

FIG. 2

Collect access events from
access control devices — 302

Obtain trend reports and
average trend report — 304

Detect faults — 306

Determine reference number
of access events — 308

Determine battery
lifespan for each access
control device — 310

Provide battery
lifespan report to
remote device — 312

300

FIG. 3

FIG. 4

| ID | Days until low voltage condition |
|---|---|
| Room 101 | 100 |
| Room 202 | 500 |
| Fitness Center | 25 |
| Room 303 | FAULT |

FIG. 5

EP 3 550 530 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5046084 A